# EUROPEAN PATENT APPLICATION

(11) **EP 2 813 976 A2**
(43) Date of publication of application: **17.12.2014**
(21) Application number: 14167000.0
(22) Date of filing: 05.05.2014
(51) Int. Cl.: G06K 19/077

(54) **Electronic product enclosure and related electronic product**

(30) Priority: 14.06.2013 CN 201310234736
(71) Applicant: Huawei Device Co., Ltd., Longgang District Shenzhen Guangdong 518129 (CN)
(72) Inventor: Kuang, Mingqiang, 518129 Shenzhen (CN); Guo, Junsheng, 518129 Shenzhen (CN)
(74) Representative: Epping - Hermann - Fischer

(57) **Abstract**

Embodiments of the present invention relate to communication accessory technologies, and provide an electronic product enclosure and an electronic product equipped with the electronic product enclosure to prevent an SIM card from risks of deformation and damage due to heating. In the embodiments of the present invention, the electronic product enclosure includes a first chamber configured to accommodate a user card and a second chamber configured to accommodate a heating device, where a thermal insulating plate is placed between the first chamber and the second chamber. The present invention is mainly applied in the field of communications.

## Description

### TECHNICAL FIELD

The present invention relates to communication accessory technologies, and in particular, to an electronic product enclosure and an electronic product equipped with the electronic product enclosure.

### BACKGROUND

For an electronic product in a vehicle, for example, a wireless router used in onboard Internet, an SIM (Subscriber Identity Module, subscriber identity module) card needs to be seated inside the electronic product to implement network connection operations. The SIM card is a smart card and is mainly applied in communications.

The current SIM card includes a card base and a chip set on the card base, where the card base uses a polymer plastic material, for example, resin, and therefore the normal operating ambient temperature of the SIM card ranges from -20 degrees Celsius to 70 degrees Celsius. However, the internal ambient temperature of a vehicle-mounted electronic product is usually higher than the maximum temperature limit of 70 degrees Celsius, which causes the temperature of the SIM card in the vehicle-mounted electronic product to be higher than 70 degrees Celsius, thereby exposing the SIM card to risks of deformation and damage. In addition, the ambient temperature in the vehicle is unstable and changes constantly between a high temperature and a low temperature. The constant change between the high temperature and the low temperature plays an important role in the deformation of the SIM card. Therefore, cooling processing is critical to the SIM card of onboard Internet.

In the electronic product that is equipped with the SIM card and mounted in the current vehicle, the card base of the SIM card is usually optimized to prevent deformation of the SIM card. Specifically, the card base of the SIM card is changed from half-enclosed to fully enclosed. However, this change cannot keep the operating ambient temperature of the SIM card within an appropriate range, which still has a great impact on the physical appearance and performance of the SIM card.

### SUMMARY

Embodiments of the present invention provide an electronic product enclosure and an electronic product equipped with the electronic product enclosure, in order to prevent an SIM card from deformation and damage due to heating.

To achieve the foregoing objectives, the embodiments of the present invention use the following technical solution:
According to a first aspect of the present invention, an electronic product enclosure includes a first chamber configured to accommodate a user card and a second chamber configured to accommodate a heating device, where a thermal insulating plate is placed between the first chamber and the second chamber.

In a first possible implementation manner of the first aspect, at least one first through-hole and at least one second through-hole are made separately on opposite surfaces of the electronic product enclosure on the first chamber side.

With reference to the first aspect or the first possible implementation manner of the first aspect, in a second possible implementation manner, the thermal insulating plate uses an aluminum foil material.

With reference to the first aspect or the first possible implementation manner of the first aspect or the second possible implementation manner of the first aspect, in a third possible implementation manner, the thermal insulating plate employs a thin plate structure.

With reference to the first aspect or the first possible implementation manner of the first aspect or the second possible implementation manner of the first aspect or the third possible implementation manner of the first aspect, in a fourth possible implementation manner, the user card is an SIM card.

According to a second aspect of the present invention, an electronic product includes the foregoing electronic product enclosure and a circuit board situated inside the electronic product enclosure; a thermal insulating plate of the electronic product enclosure separates a circuit board portion in a first chamber of the electronic product enclosure from a circuit board portion in a second chamber of the electronic product enclosure; a user card in the first chamber is electrically connected to the circuit board in the first chamber; and a heating device in the second chamber is seated on the circuit board in the second chamber.

In a first possible implementation manner of the second aspect, a groove is made on a surface of the circuit board located between the user card and the thermal insulating plate in the first chamber.

With reference to the second aspect or the first possible implementation manner of the second aspect, in a second possible implementation manner, a third through-hole is made on the circuit board located between the user card and the thermal insulating plate in the first chamber.

In the electronic product enclosure and the electronic product equipped with the electronic product enclosure provided by the embodiments of the present invention, a first chamber and a second chamber are made available and are separated by a thermal insulating plate, so that heat produced by a heating device seated in the second chamber cannot be transferred, through heat convection, to the first chamber in which a user card is located. Therefore, a suitable, stable ambient temperature is ensured for the user card in the first chamber, which in turn ensures a suitable, stable temperature of the user card and prevents deformation and damage of the user card due to heating.

### BRIEF DESCRIPTION OF DRAWINGS

To describe the technical solutions in embodiments of the present invention more clearly, the following briefly introduces the accompanying drawings required for describing the embodiments.
FIG. 1 is a schematic structural diagram of an electronic product enclosure according to an embodiment of the present invention; and
FIG. 2 is a schematic structural diagram of an electronic product according to an embodiment of the present invention.

### DESCRIPTION OF EMBODIMENTS

The following clearly and completely describes the technical solutions in the embodiments of the present invention with reference to the accompanying drawings in the embodiments of the present invention.

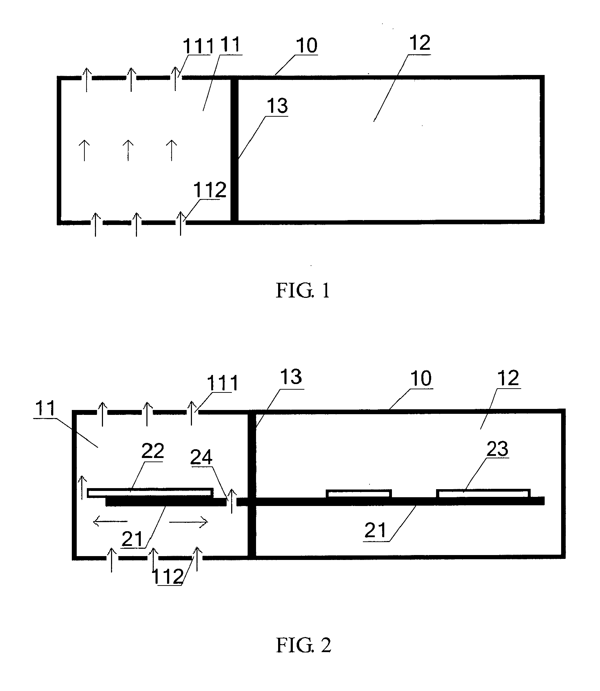

As shown in FIG. 1, an embodiment of the present invention provides an electronic product enclosure 10, including a first chamber 11 configured to accommodate a user card and a second chamber 12 configured to accommodate a heating device, where a thermal insulating plate 13 is placed between the first chamber 11 and the second chamber 12.

In the electronic product enclosure provided by this embodiment of the present invention, the first chamber and the second chamber are made available and are separated by a thermal insulating plate, so that heat produced by a heating device seated in the second chamber cannot be transferred, through heat convection, to the first chamber in which a user card is located. Therefore, a suitable, stable ambient temperature is ensured for the user card in the first chamber, which in turn ensures a suitable, stable temperature of the user card and prevents deformation and damage of the user card due to heating.

It should be noted herein that the components accommodated in the first chamber and the second chamber of the electronic product enclosure do not need to be limited, that is, the second chamber may also accommodate the user card and the first chamber may also accommodate the heating device. In addition, other mechanical parts are also placed inside the electronic product enclosure, for example, a circuit board and a fixing bracket, and the user card and the heating device are connected to other mechanical parts.

Heat is mainly transferred in the following three modes, namely, heat conduction, heat convection, and heat radiation. Heat conduction means in which heat is transferred between a high-temperature object and a low-temperature object that are in direct contact with each other. Heat convection is a phenomenon in which heat is transferred from one place to another place through a flowing medium. Heat radiation is a phenomenon in which an object with a temperature radiates electromagnetic waves (the cooling effect is mainly related to a material and structure of a surface of the heating device.) During actual heat transfer, the foregoing three modes generally coexist and work together. However, in this embodiment, heat is transferred between the first chamber and the second chamber mainly by using the heat convection mode.

During specific implementation, as shown in FIG. 1, at least one first through-hole 111 and at least one second through-hole 112 may be made separately on opposite surfaces of the electronic product enclosure 10 on the first chamber 11 side. The thermal insulating plate 13 can prevent a large amount of heat produced in the second chamber from being transferred to the first chamber. In addition, the ambient temperature in the first chamber can be further reduced when there are multiple first through-holes 111 and multiple second through-holes 112. The first through-hole 111 and the second through-hole 112 can accelerate heat dissipation in the first chamber 11, and in addition, make air circulation in the first chamber possible. A through-hole may also be made on a surface, which is opposite to the thermal insulating plate, of the electronic product enclosure 10 on the first chamber 11 side, in order to further accelerate heat dissipation.

In this embodiment, air around the electronic product enclosure enters from the first through-hole 111 or the second through-hole 112, and flows out from the second through-hole 112 or the first through-hole 111, to provide air circulation and accelerate temperature reduction of the user card. FIG. 1 illustrates an example case in which the first through-hole 111 serves as an air outlet, and the second through-hole 112 serves as an air inlet, and the arrow in FIG. 1 represents an air flow direction. The first through-hole 111 or the second through-hole 112 may have air inflow and air outflow concurrently.

In the electronic product enclosure described in the foregoing embodiment, the thermal insulating plate 13 may use an aluminum foil material and may employ a thin plate structure. The choice of a thin plate structure for the thermal insulating plate 13 is mainly driven by the overall manufacturing process and processing costs of the electronic product enclosure. In addition, the aluminum foil material has a good capability to keep heat out and can better prevent heat in the second chamber 12 from being transferred to the first chamber 11. Apparently, the thermal insulating plate 13 may also be designed in other structures and can use other thermal insulating materials.

In actual applications, the user card may be a common SIM card, and may also be other types of cards.

An embodiment of the present invention further provides an electronic product. As shown in FIG. 2, the electronic product includes the foregoing electronic product enclosure 10 and a circuit board 21 inside the electronic product enclosure 10. The thermal insulating plate 13 of the electronic product enclosure 10 separates a circuit board 21 portion in the first chamber 11 of the electronic product enclosure 10 from a circuit board 21 portion in the second chamber 12 of the electronic product enclosure 10. A user card 22 in the first chamber 11 is electrically connected to the circuit board 21 in the first chamber 11, and a heating device 23 in the second chamber 12 is fixed on the circuit board 21 in the second chamber 11.

The electronic product provided by this embodiment of the present invention uses the foregoing electronic product enclosure, where a first chamber and a second chamber are made available in the enclosure and are separated by a thermal insulating plate, so that heat produced by a heating device set in the second chamber cannot be transferred, through heat convection, to the first chamber in which a user card is located. Therefore, a suitable, stable ambient temperature is ensured for the user card in the first chamber, which in turn ensures a suitable, stable temperature of the user card and prevents deformation and damage of the user card due to heating.

It should be noted herein that the circuit board 21 is an overall mechanical part, and can pass through the thermal insulating plate 13, and can also be in seamless contact with the thermal insulating plate 13 (At this time, the circuit board 21 is attached to an interior wall of the electronic product enclosure 10). In addition, the user card is connected to the circuit board 21 through a card base of the user card.

In the electronic product described in the foregoing embodiment, as shown in FIG. 2, a groove (not illustrated in FIG. 2) may be made on a surface of the circuit board 21 located between the user card 22 and the thermal insulating plate 13 in the first chamber 11. The heating device 23 is fixed on the circuit board, so that heat produced by the heating device 23 can be transferred to the user card 22 through the circuit board 21; however, this increases the temperature of the user card 22 and causes a negative effect on the user card. Considering that the heat transferred by the circuit board 21 is very low compared with the heat produced by the heating device 23, the effect of the heating device 23 on the temperature of the user card 22 is the main problem, that is, heat convection is the main heat transfer mode in this embodiment. In FIG. 2, a groove (this groove does not affect functions of the circuit board 21) is made on the circuit board 21 located between the user card 22 and the thermal insulating plate 13, so that a certain gap exists between the bodies of the circuit board 21 located on the left side and on the right side of the groove. In this way, heat transferred in the circuit board 21 can be reduced through this gap, and heat dissipation is accelerated at the position of the groove. Apparently, a heat-absorbing bar or other cooling structures or cooling apparatuses may also be seated on the circuit board 21 between the user card 22 and the thermal insulating plate 13 to absorb heat.

In the electronic product described in the foregoing embodiment, as shown in FIG. 2, a third through-hole 24 may be made on the circuit board 21 located between the user card 22 and the thermal insulating plate 13 in the first chamber 11.

The third through-hole 24 can also play a same role as the foregoing groove, and the number of third through-holes 24 is not limited and may be determined according to an actual need. When the first through-hole 111 and the second through-hole 112 form an air inlet and an air outlet to allow air circulation, air flow in the first chamber may be blocked, because the circuit board 21 and the user card 22 are seated inside the first chamber 11. Therefore, by using the third through-hole 24, air flow paths and air flow speed are increased, so as to speed up heat dissipation of the user card. In FIG. 2, a through-hole may also be made on a surface of the electronic product enclosure 10 that is close to the user card and opposite to the thermal insulating plate 13, in order to further accelerate dissipation of the heat.

In actual applications, the groove and the third through-hole 24 cannot affect other parts or circuits on the circuit board 21. Therefore, the groove and the third through-hole 24 need to be seated according to a specific structure of the circuit board 21.

In addition, a cooling structure similar to the through-hole may also be situated on the electronic product enclosure 10 on the second chamber 12 side to indirectly reduce the temperature of the user card, where the heating device 23 is accommodated in the second chamber 12 to accelerate heat dissipation of the second chamber 12.

The foregoing descriptions are merely specific implementation manners of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. An electronic product enclosure, comprising a first chamber configured to accommodate a user card and a second chamber configured to accommodate a heating device, wherein a thermal insulating plate is placed between the first chamber and the second chamber.

2. The electronic product enclosure according to claim 1, wherein at least one first through-hole and at least one second through-hole are made separately on opposite surfaces of the electronic product enclosure on the first chamber side.

3. The electronic product enclosure according to claim 1 or 2, wherein the thermal insulating plate uses an aluminum foil material.

4. The electronic product enclosure according to any one of claims 1 to 3, wherein the heat-insulation plate is designed in a thin plate structure.

5. The electronic product enclosure according to any one of claims 1 to 4, wherein the user card is an SIM card.

6. An electronic product, comprising the electronic product enclosure in any one of claims 1 to 5 and a circuit board seated inside the electronic product enclosure, wherein a thermal insulating plate of the electronic product enclosure separates a circuit board portion in a first chamber of the electronic product enclosure from a circuit board portion in a second chamber of the electronic product enclosure;
a user card in the first chamber is electrically connected to the circuit board in the first chamber; and a heating device in the second chamber is seated on the circuit board in the second chamber.

7. The electronic product according to claim 6, wherein a groove is made on a surface of the circuit board located between the user card and the thermal insulating plate in the first chamber.

8. The electronic product according to claim 6 or 7, wherein a third through-hole is made on the circuit board located between the user card and the thermal insulating plate in the first chamber.
